# EUROPEAN PATENT APPLICATION

(11) **EP 0 786 868 A1**
(43) Date of publication of application: **30.07.1997**
(21) Application number: 97300484.9
(22) Date of filing: 27.01.1997
(51) Int. Cl.: H03K 5/156, H03K 23/66, H03K 23/68, G06F 7/62

(54) **Division of input frequency to digitally derive arbitrary output frequency**

(30) Priority: 29.01.1996 US 593599
(71) Applicant: Hewlett-Packard Company, Palo Alto, California 94304 (US)
(72) Inventor: Puckette, Robert B.E., Corvallis, OR 97330 (US)
(74) Representative: Colgan, Stephen James

(57) **Abstract**

An output clock signal (14/26/42) is derived from a source clock signal (12/24) by taking the closest corresponding transition of the source clock signal as the output clock signal transition. As a result, the output clock signal dithers between a divide by n of the source clock signal and a divide by n+1 of the source clock signal. The dithering is performed in a pattern so as to achieve the closest corresponding transition and thus define an accurate output signal frequency. For example, a three-term pattern includes normally dividing by n, the first term. Every m (the second term) sets of n source clock signal periods, the active transition is instead after n+1 source clock signal periods. Every p (the third term) sets of m, the m sets are instead m+1 sets before the active transition occurs at the n+1 source clock signal transitions.

## Description

### BACKGROUND OF THE INVENTION

This invention relates generally to methods and apparatus of digital frequency division, and more particularly to deriving an arbitrary output frequency from an input frequency.

Digital computing systems typically include circuits operating at differing clock frequencies. Rather than create each signal from its own unique source (e.g., individual crystal oscillator), it is preferred that various clock signals be derived from as few reference sources as possible. For example, a single crystal oscillator may be included for a given computer or for each digital computing board in the computer (e.g., main processor board, graphics board, video board). The reference clock frequency of a given crystal oscillator is then used to derive all the various clock signals need on the board or in the computer. There is a challenge, however, in deriving an output clock signal from a source clock signal, where the output frequency is not evenly dividable into the source clock frequency.

Consider the example where an accurate 14.31818 MHz output clock signal is desired to be derived from a 40 MHz crystal oscillator source clock signal. Using analog techniques one would use analog phase locked loops to achieve the output clock signal frequency. To reduce power requirements and limit analog devices in the digital computer, however, a digital technique is desirable. Using digital techniques one would divide the 40 MHz signal. Dividing the 40 MHz signal involves taking a given number of reference clock signal periods as the output lock period. Thus, a divide by two operation results in two 40 MHz clock periods taken together as the output clock signal period - (i.e., double the period equals one-half the frequency - 20 MHz.). A divide by two is easily performed. However, achieving any arbitrary output frequency is difficult. A divide by "pi", for example, is not achievable using conventional digital methods.

Accordingly, there is a need for a method and apparatus for achieving an arbitrary frequency output signal from a source clock signal. In particular there is a need for a method and apparatus for achieving an output clock signal frequency which is not evenly divided into the source clock signal.

### SUMMARY OF THE INVENTION

According to the invention, an output clock signal is derived from a source clock signal by taking the closest corresponding transition of the source clock signal as the output clock signal transition. Over the long term, an average output clock frequency is achieved which is not evenly divided into the source clock frequency. Consider the example of achieving an average output frequency which is the 40 MHz source clock frequency divided by pi. For several output signal clock cycles, the closest corresponding source clock transition is every third source clock period (e.g., divide by three instead of the divide by pi = 3.14...). Every so often, however, the closest corresponding source clock transition is the fourth source clock period. Thus, the output clock signal frequency most often is a divide by 3 of the source clock signal, but sometimes it is a divide by 4. In the example, every seven sets of 3 source clock periods, the output clock signal transition is taken as the fourth period rather than the third period. Note, however, that with "pi" as the desired divisor the pattern does not repeat every 7 sets of 3 source clock periods. Most often the pattern repeats every seven sets of 3 source clock periods. However, sometimes the closest transition results in waiting for the 8-th set of 3 instead of the 7-th set of 3.

According to one aspect of this invention, an arbitrary output frequency is digitally derived from a source clock frequency by a partial fractional expansion of the source frequency. At a first step, the integer part of the desired frequency division is used as a first term, (e.g., 40 MHz divided pi yields 3 as the integer part and a first remainder of 0.14...). To find a succeeding term the remainder is inverted, then the integer portion is taken as the next term, (e.g., 1/.14... = 7.06... - thus 7 is the next term). The inversion of the remainder is done for as many succeeding terms as desired for a given accuracy requirement. In the example of 40 MHz divided by pi, the first three terms are 3, 7, and 16. Expanding the derivation out merely to three terms in this example provides for an error of under 100 parts per billion output signal clock cycles.

According to another aspect of the invention, the terms of the partial fractional expansion define divide-by terms. Generally, an output frequency transition occurs every n-th source clock signal periods where n is the first term. For a second term "m", every m sets of n source clock signal periods, the output frequency transition occurs at the n + 1-th source clock signal period. For a third term "p", every p sets of the m sets, one waits instead m + 1 sets of the n periods before making an output clock transition at the n + 1-th source clock signal period. Such adjustments continue out for each of j terms. In the examples described above j = 3 terms.

According to another aspect of the invention, a chain of dividers or programmable dividers implement the division of the source clock signal to digitally derive an arbitrary output clock frequency. One divider is set to divide by the first term, (e.g., 3 in the example 40/pi). The next divider is set to divide by the second term, (e.g., 7 in the example 40/pi). The next divider is set to divide by the third term, (e.g. 16 in the example 40/pi). For j=3 that is the complete chain. For other examples the chain of dividers continues on for additional terms, (e.g., j > 3). The result of the divider chain is an output clock signal that has a period which dithers so as to average out over the long term to a desired frequency, (e.g., an arbitrary frequency not evenly divisible into a fixed source signal frequency).

One advantage of the invention is that a source clock frequency can be divided accurately to achieve any arbitrary output frequency. Of significance is the achievement of accurate output frequencies which are not evenly divided into the source clock frequency. A beneficial effect is that many diverse output clock signals of differing frequency can be digitally derived from a common source clock signal. These and other aspects and advantages of the invention will be better understood by reference to the following detailed description taken in conjunction with the accompanying drawings.

### BRIEF DESCRIPTION OF THE DRAWINGS

Fig. 1 is a block diagram of an apparatus for deriving an arbitrary output signal frequency from a fixed source signal frequency according to an embodiment of this invention;
Fig. 2 is a block diagram of a 3-stage apparatus for dividing a 40 MHz source clock signal by pi to achieve an output clock signal according to an embodiment of this invention;
Fig. 3 is a block diagram of a 3-stage apparatus for deriving a 14.31818 MHz output signal from a 40 MHz source signal according to an embodiment of this invention;
Fig. 4 is a chart of waveforms showing the derivation of the output signal from the source signal for the Fig. 3 embodiment;
Fig. 5 is a block diagram of a 2-stage apparatus for deriving a 14.31818 MHz output signal from a 40 MHz source signal according to an equivalent embodiment of this invention; and
Fig. 6 is a chart of waveforms showing a pattern of output clock signal dithering according to an embodiment of this invention.
Fig. 7 is a chart of waveforms showing a desired output clock and a pattern of output clock signal dithering according to an embodiment of the invention.

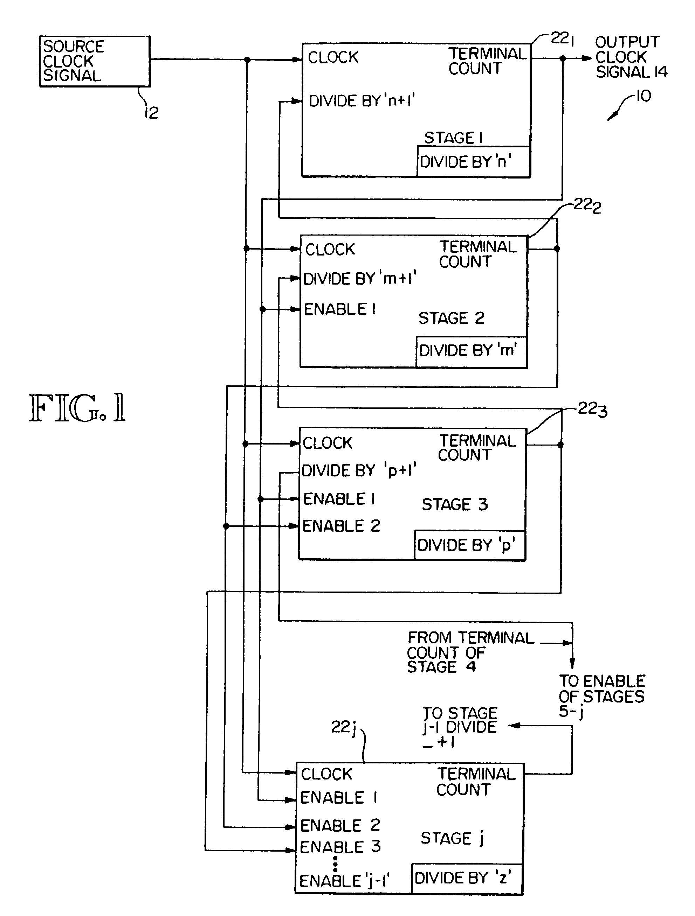

Fig. 1 shows an apparatus 10 for deriving any arbitrary output clock signal 14 from a source clock signal 12 according to an embodiment of this invention. The output clock signal 14 is derived by taking the closest corresponding transition of the source clock signal 12 as the output clock signal transition. In effect, the output clock signal frequency is dithered. Over the long term output clock frequency averages out to the desired arbitrary output clock signal frequency. As a result, an output clock signal 14 of any frequency is digitally derived from a given fixed frequency source clock signal 12.

Fig. 1 shows the source clock signal 12 input to a chain of dividers, (e.g., part no. 74161 dividers). The chain includes j stages of dividers. Each stage defines a divide by operation. Stage 1 is a divide by n operation. Stage 2 is a divide by m operation. Stage 3 is a divide by p operation. The divide-by term for each stage is defined by a partial fractional expansion of the source frequency divided by the desired frequency. The output signal from the first stage is the output clock signal 14. The output signal from the first stage also is fed to an enable input of each successive stage. Each subsequent stage beyond the first stage has an output signal fed back to the prior stage which adjusts the divide by count of the prior stage for one cycle. According to the preferred embodiment the output signal of each such stage increments the divide by term of the predecessor stage for one cycle. The output signal of each stage also is fed to an enable input of any subsequent stage. As a result, the first stage division is altered each time the second stage counts out. The second stage division is altered each time the third stage counts out. Thus, a pattern is defined for the output clock signal 14.

Normally the apparatus 10 generates an active transition of the output clock signal 14 every n source clock signal 12 periods. This is achieved by dividing the source clock signal 12 by n at stage 1. Every m sets of n source clock signal periods, however, an active transition of the output clock signal 14 is generated instead after n + 1 source clock signal 12 periods. This is achieved by feeding the stage 2 output back to stage 1 to alter the divide by count from n to n+1 for one cycle. Every p sets of m count outs, however, the divide by m count is changed to divide by m+1 for one cycle. This is achieved by feeding back the stage three output back to stage 2 to alter the divide by count from m to m+1. Thus, every time stage 3 counts out m+1 is used as the number of sets of n source clock signal periods that occur before instead using n+1 source clock signal periods to generate an active transition of the output clock signal. The pattern continues on for as many stages as desired. The number of stages is selected based upon the desired accuracy for the output clock signal 14 frequency.

### Partial Fractional Expansion

The terms for each divider stage 22ᵢ (for i = 1, j) are defined using a partial fractional expansion. Specifically, the desired output frequency is divided by the source clock signal 12 frequency yielding an integer part and a fractional part. If there is only an integer part then the output frequency is evenly divisible into the source frequency so a simple one stage division of the source clock signal 12 suffices. Such a case is achieved via conventional methods and apparatus. However, for a desired output frequency which is not evenly divisible into the source clock frequency, the result is a first integer part and a first remainder part. The integer part is taken as the divide by term, 'n', for stage 1 (22₁). The first remainder part then is inverted yielding a second integer part and either zero remainder or a non-zero fractional remainder. The second integer is taken as the divide by term, 'm', for the second stage 22₂. If the second remainder is 0, then all that is used is a two stage (i.e., j=2) embodiment to achieve the desired output frequency. If there is a non-zero second fractional remainder, then such remainder is inverted yielding a third integer part and either a zero or non-zero third fractional remainder. The third integer part is taken as the divide by term, 'p' of the third stage 22₃. If the third remainder is zero, then all that is used is a three stage (i.e., j=3) embodiment. Otherwise, the inversion and fractional expansion continues out to a desired number of stages or until a zero remainder is achieved. Note that even when there is a non-zero remainder, one may discontinue the expansion and not define any more divide-by terms. The number of stages 22 is determine by the accuracy desired for the output clock signal frequency.

### Divide by 'pi' Embodiment

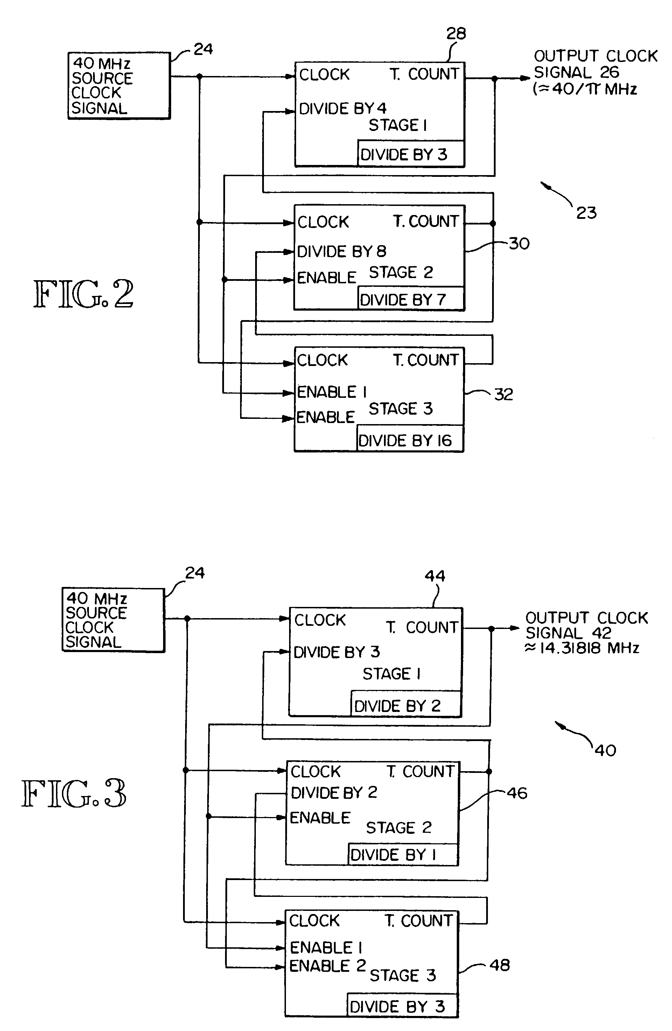

Fig. 2 shows a specific embodiment 23 of the Fig. 1 apparatus in which a 40 MHz source frequency signal 24 is divided by pi. This is the most difficult case because there will always be a non-zero remainder in the fractional expansion. However, by doing an expansion out for 3 stages, (i.e., j=3) an output clock signal 26 is achieved which is accurate to an error rate of under 100 per billion output signal clock cycles. Doing a fractional expansion of pi gives 3 as the first integer part and 0.14... as the first remainder. Thus, n = 3. The first remainder 0.14... then is inverted yielding 7.06.... Thus, 7 is the second integer part and 0.06... is the second remainder part. The divide-by m term then is set to 7. The second remainder 0.06.. then is inverted yielding 16 as the third integer part. The expansion could continue on, but for a three stage apparatus as shown in Fig. 2, the divide-by terms are now defined for each stage, (i.e., n=3, m=7 and p=16).

Note that the 40 MHz source clock signal 24 normally is divided by 3, but every 7th time that the first stage 28 would count out, the divide by is instead extended to divide by 4. Thus, for six counts stage 1 divides by 3, while for the seventh count out the first stage 28 divides by 4. Further, every 16th time the second stage 30 counts out, the divide by 7 of the second stage 30 is extended to count out as a divide by 8. The third stage 32 defines the divide-by 16 operation. Thus, a pattern is achieved for the output clock signal 26 to dither between a 40 MHz / 3 signal and a 40 Mhz / 4 signal so that on average the output signal is 12.7273 MHz (i.e., 40/pi MHz).

### Derivin a 14.31818 MHz Output Clock from the 40 MHz Source Clock

Fig. 3 shows another exemplary embodiment 40 of the Fig. 1 apparatus. In the Fig. 3 embodiment, a 1431818 MHz output clock signal is desired. Conventionally, one could not derive such a clock signal from a 40 MHz source clock signal using digital techniques. However, using the partial fractional expansion approach to define divide-by terms of successive stages in a chain of digital dividers yields: a first term, n = 2; a second term, m = 1; and a third term p = 3. For the embodiment illustrated the expansion is taken to three stages, (i.e., j =3).

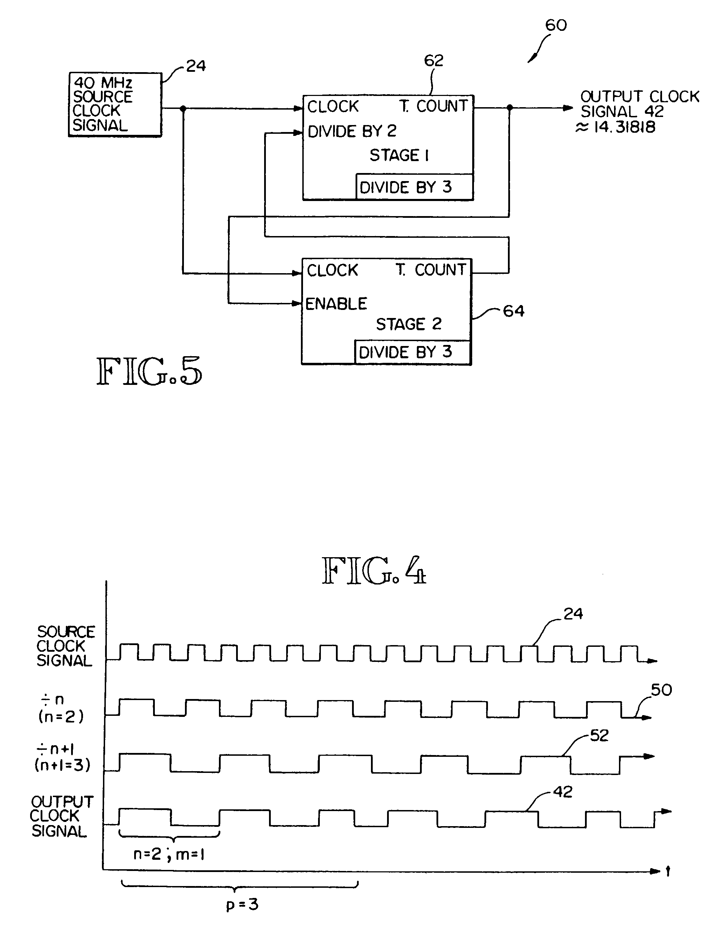

Fig. 4 shows the 40 MHz source clock signal 24 and three stages 44, 46, 48 of dividers. Referring to Fig. 3 the first stage 44 is a divide by 2 operation. Fig. 4 shows a divide by 2 signal 50 of the source clock signal. The second stage 46, however, has a divide by term, m=1. Thus, for every count out of the first stage 44 the second stage 46 output goes active, signifying the first stage 44 to instead do a divide by 3. Fig. 4 shows a divide by 3 signal 52. However, factoring in the third stage 48, there is a third divide by term, p = 3. Thus, every third count out of the second stage 46, the divide by count changes from 1 to 2. The resulting output clock signal 42 is shown in Fig. 4. Note the pattern in which output signal 42 dithers between a divide by 3 and a divide by 2 of the source signal 24.

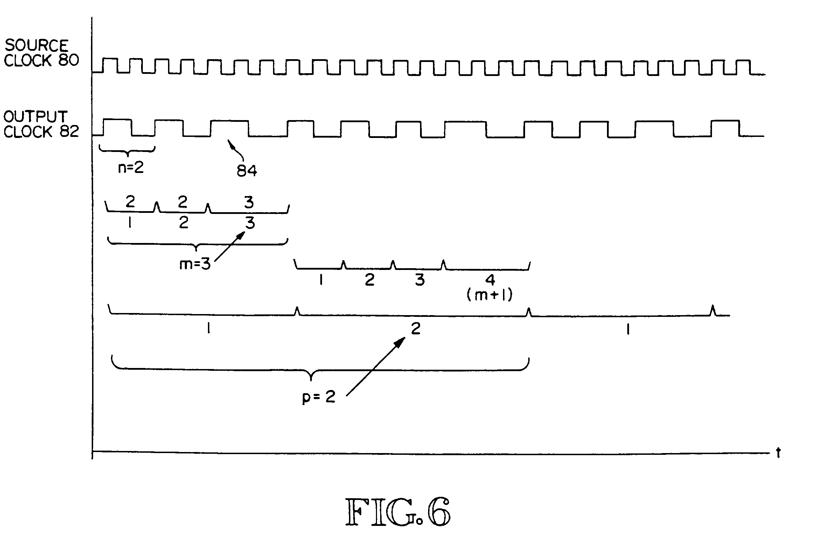

Fig. 5 shows an equivalent embodiment 60 of the apparatus 40 shown in Fig. 3. Note that the same 14.31818 MHz dithered signal 42 is achieved from the 40 MHz fixed source clock signal 24 as in the Fig. 3 embodiment 40. Apparatus 60, however, is reduced to two stages 62, 64 by combining the second stage 46 count of Fig. 3 with the first stage 44 count of Fig. 3. Also note that the second stage 64 of apparatus 60 is the same as the third stage of apparatus 40. Each time stage 64 counts out, however, the output signal fed back to the prior stage, stage 62, decrements the divide-by term (e.g., 3 - 1 = 2), instead of incrementing such term as according to apparatus 40. Referring to Fig. 4, the source clock signal 24 and output clock signal 42 are the same for both apparatus 40 and 60. Of significance is that the three divider stages 44-48 of apparatus 40 are reduced to an equivalent structure having two stages 62-64 in apparatus 60. Note that the equivalent apparatus 60 is achieved by allowing substraction as well as addition in perfroming the partial fractional expansion. For a stage performing a divide by x and incrementing to a divide by x+1 on a count out of the subsequent stage, an equivalenet structure can be found for dividing by x+1, then decrementing to a divide by x when a subsequent stage counts out. The same shaped output curve can be achieved using any of alternate equivalent structures. Such variation is preferred for cases in which a stage can be eliminted, as in the Fig. 5 embodiment.

### Output Clock Signal Patten

Fig. 6 shows a source clock signal 80 and an output clock signal 82 derived according to an embodiment of this invention. Note that the first order pattern (stage 1) has the source clock signal divided by 2. Thus, a first stage divide-by term n is set to 2. Also note that every third period of the output clock signal 82, the source clock signal 80 is instead divided by n+1=3. Thus, a second stage divide-by term m is set to 3 (corresponding to the variation occurring at the third period 84). Also, note that every other count out of m, m is altered from m= 3 to m = 4. Thus, a third stage divide-by term p is set to 2. Thereafter the pattern 88 repeats.

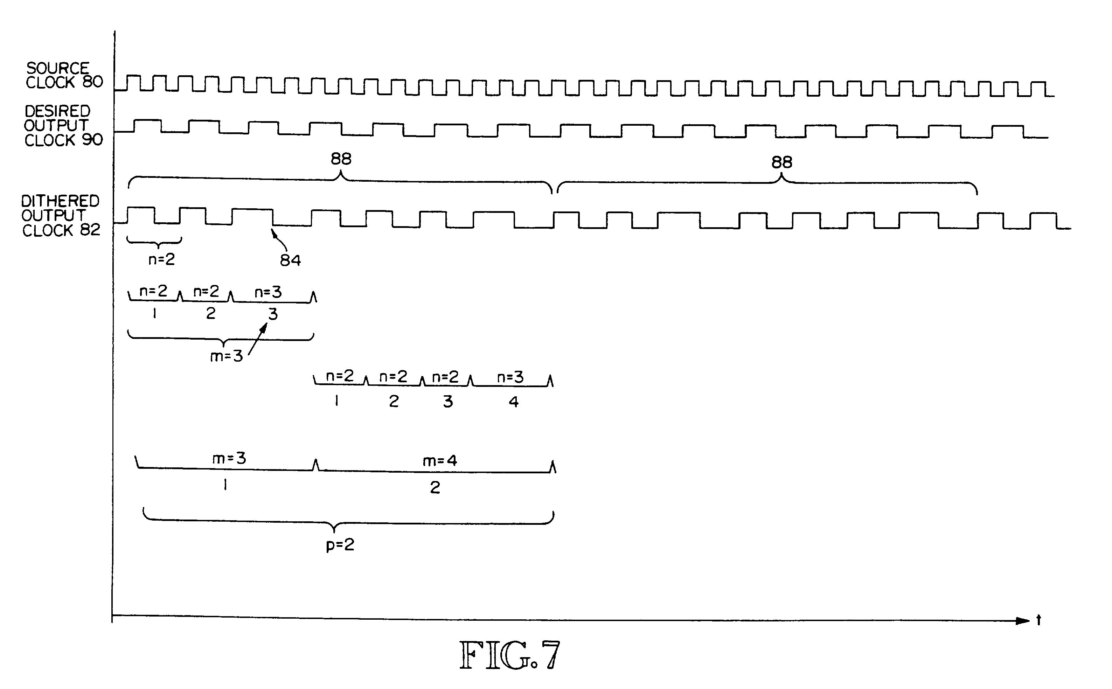

Consider the example in which the source clock signal 80 is 40 MHz and the desired output clock signal 90 is 17.5 MHz. The divide-by terms are n = 2, m = 3, and p = 2 as shown in Fig. 7. Note that the active transitions of the dithered output signal 82 occur at the nearest active transition of the source clock signal 80 closest to the transition in the desired output signal 90.

### Meritorious and Advantageous Effects

One advantage of the invention is that a source clock frequency can be divided accurately to achieve any arbitrary output frequency. Of significance is the achievement of accurate output frequencies which are not evenly divided into the source clock frequency. A beneficial effect is that many diverse output clock signals of differing frequency can be digitally derived from a common source clock signal. Although a preferred embodiment of the invention has been illustrated and described, various alternatives, modifications and equivalents may be used. Therefore, the foregoing description should not be taken as limiting the scope of the inventions which are defined by the appended claims.

## Claims

1. A method for digitally deriving an output clock signal (14/26/42) from a source clock signal (12/24), the source clock signal having a fixed frequency, the output clock signal having a clock period defined by a varying number of source clock signal periods, the method comprising the steps of:
defining a set of j divide-by terms using a partial fraction expansion of the source clock signal frequency divided by a desired output clock signal frequency, wherein the first divide-by term is n; and
defining a pattern for dithering the output clock signal period as a function of the j divide-by terms.

2. The method of claim 1 in which the step of defining a pattern comprises dividing the source clock signal frequency in a serial chain of frequency division circuitry stages (22/ 28-32/ 44-48/ 62-64), each one of the stages performing a frequency division using a divide factor defined by a corresponding one of the j divide-by terms; and wherein any one stage in the serial chain other than a last stage has the divide factor altered in response to a count-out of an immediately successive stage.

3. The method of claim 2 in which a given first stage (22/ 28-30/ 44-46/62) has its factor either one of incremented or decremente in response to a count-out of the first stage's immediately succesive stage (22/32/48/64).

4. The method of claim 3 for digitally deriving an output clock signal (14,/26/42) from a source clock signal (12/24) by taking a closest corresponding transition of the source clock signal as an active transition of the output clock signal, the output clock signal having a desired frequency which is not evenly dividable into the fixed frequency, the fixed frequency divided by the desired frequency having a first integer part and a first remainder part, the first integer part equal to n, an inversion of the first remainder part having a second integer part and a second remainder part, the second integer part being m, and in which the step defining a set comprises defining i clock division terms where i = 1, j and j ≥ 2, and wherein the i=1 clock division term is the first integer part, and wherein the i=2 clock division term is the second integer part; and further comprising the steps of:
actively transitioning the output clock signal every n source clock signal periods; and
altering the transitioning of the output clock signal to generate an active output clock signal transition for the n+1-th source clock signal period instead of the n-th source clock signal period after a determined number of sets of n source clock signal periods; wherein for j=2 the determined number is m; whererin for j>2, the determined number varies.

5. The method of claim 4, in which for j=3, an inversion of the second remainder part has a third integer part and a third remainder part, the third integer part being p, and in which the determined number varies between m and m+1, and wherein every p groups of m sets of n source clock signal, the determine number is m+1 instead of m.

6. An apparatus (10/23/40/60) for digitally deriving an output clock (14/26/42) signal from a source clock signal, the source clock signal having a fixed frequency, the output clock signal having a clock period defined by a varying number of source clock signal periods, the apparatus comprising:
a plurality of dividers (22/28-32/44-48/62-64) serially coupled for dithering the output clock signal period between a varying number (n & n+1) of source clock signal periods, each one of the plurality of dividers having a divide-by term (n,m,p);
wherein each one divide-by term is defined by a partial fractional expansion of the fixed frequency divided by a desired frequency of the output clock signal; and
wherein the divide-by term for a respective divider other than a last divider of the serially coupled plurality of dividers is altered for a cycle in response to a count-out of an immediately successive divider among the serially coupled plurality of dividers.

7. The apparatus of claim 6 in which the divide-by term of one divider is either one or incremented or decremented in response to a count-out of a divider coupled immediately succesive to said one divider.
